Europäisches Patentamt

**European Patent Office**

Office européen des brevets

(11) Publication number: **0 264 309 B1**

## EUROPEAN PATENT SPECIFICATION

(45) Date of publication of patent specification: **28.08.91** (51) Int. Cl.5: **H01L 21/285, H01L 29/62**

(21) Application number: **87402029.0**

(22) Date of filing: **11.09.87**

(54) **Self-aligned base shunt for transistor.**

(30) Priority: **11.09.86 US 906350**

(43) Date of publication of application:
**20.04.88 Bulletin 88/16**

(45) Publication of the grant of the patent:
**28.08.91 Bulletin 91/35**

(84) Designated Contracting States:
**DE FR GB IT NL**

(56) References cited:
**EP-A- 0 110 211**
**EP-A- 0 159 179**
**EP-A- 0 168 324**
**GB-A- 2 168 845**
**US-A- 4 199 380**

(73) Proprietor: **FAIRCHILD SEMICONDUCTOR CORPORATION**
**10400 Ridgeview Court P.O. Box 1500**
**Cupertino, California 95014(US)**

(72) Inventor: **Cleeves, James M.**
**551 Summit Drive**
**Redwood City California 94062(US)**
Inventor: **Heard, James G.**
**10560 Glenview Avenue**
**Cupertino California 95014(US)**

(74) Representative: **Sparing Röhl Henseler Patentanwälte European Patent Attorneys**
**Rethelstrasse 123**
**W-4000 Düsseldorf 1(DE)**

## Description

This invention relates to integrated circuits and the manufacture thereof, and particularly to the fabrication of a low resistance base shunt for a bipolar transistor extending from a base contact into close proximity with an emitter region.

Description of the Prior Art

Integrated circuit designers are faced with the difficult task of fabricating circuits which operate at the highest possible speed while occupying a minimal amount of the silicon surface area. As semiconductor structures have become increasingly complex, it is difficult to fabricate all of the necessary active and passive devices within the integrated circuit in a reasonable number of process steps with a minimal number of masks, while achieving the desired performance.

One well known integrated circuit fabrication technology is the manufacture of bipolar transistors. A widely used and well known process for fabricating bipolar transistors is described in U.S. Patent 3,648,125 entitled "Method of Fabricating Integrated Circuits with Oxidized Isolation and the Resulting Structure" and issued to Douglas L. Peltzer. Peltzer teaches the use of oxide isolation to provide electrically isolated pockets of epitaxial silicon in which active and/or passive devices may be fabricated. These individual devices are then interconnected by metal or polysilicon conductors deposited across the surface of the silicon. Numerous other oxide isolated bipolar processes have been developed. In almost all of these processes, it is desired to make the transistor switch as rapidly as possible. One well known restriction on the switching speed of bipolar devices is the resistance presented by the extrinsic base region, that is, for a vertical device that portion of the base extending laterally between the emitter and the base contact.

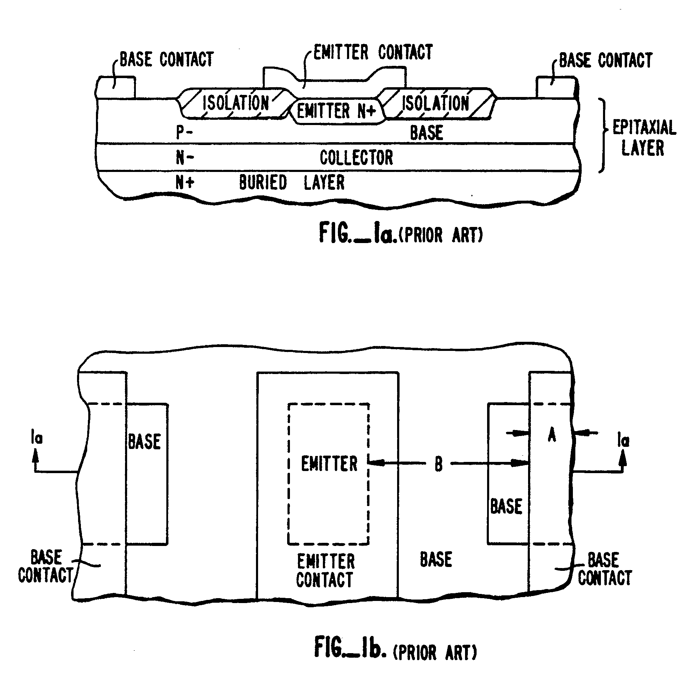

Figure 1a is a cross-sectional view of a portion of a prior art semiconductor structure. The structure depicted is a cross-section of a vertical NPN transistor. As shown, a buried layer of strongly-doped N conductivity provides a collector region under an epitaxial silicon layer. The collector is separated from the strongly-doped emitter by a base region. An emitter contact provides an electrical connection to the emitter, while a pair of base contacts provide electrical connections to the base. The emitter contact is prevented from shorting to the base region by an annular thin oxide isolation region surrounding the emitter at the upper surface of the epitaxial layer.

Figure 1b is a top view of the structure shown in Figure 1a, and illustrates a significant disadvantage of the structure. In particular, the transistor structure of Figure 1a will not switch as rapidly as desired because of the relative high resistance of the extrinsic base region. The extrinsic base region is that portion of the base extending between the emitter and the base contact. As shown in Figure 1b, the sheet resistance A of the base contact will be on the order of 0.03 ohms per square, while the sheet resistance of the extrinsic base B will on the order of 700 ohms per square. The relatively high resistance B reduces the switching speed of the transistor.

At least two techniques have been developed for lowering the resistance of the extrinsic base. According to one technique, a plug implant is employed to extend the base downward and thereby increase the collector-base capacitance. The capacitance is increased because the base region is more strongly doped in closer proximity to the collector region.

When a polycrystalline silicon contact is employed, another prior art technique for lowering the resistance of the extrinsic base is to form a spacer oxide on the sides of the polycrystalline silicon contact, and then use the spacer oxide to mask additional implantation of the substrate with base impurity to thereby more strongly dope all of the base region except that portion beneath the emitter contact and spacer oxide.

## SUMMARY OF THE INVENTION

We have developed a technique for lowering the resistance of the extrinsic base of a bipolar transistor by using a low resistance base shunt employing metal silicide. The shunt is fabricated by a self-aligned masking process in which metal or other contacts fabricated on the surface of the semiconductor are employed as a mask. The invention is particularly advantageous because it provides increased switching speeds in a highly reliable manner with a minimal number of additional masks and fabrication steps. The invention also allows the base shunt to be positioned substantially closer to the emitter of a vertical bipolar transistor than one minimum line width.

Our invention includes both a process and the resulting semiconductor structure. In a preferred embodiment, a process for fabricating the low resistance shunt of our invention consists of the steps of: in a layer of first conductivity type semiconductor material having a surface, forming an insulating region of oxidized semiconductor material to separate, at the surface, a first portion of the layer from a second portion of the layer; introducing opposite conductivity type impurity into the first portion to thereby form a doped region in contact with the insulating region; forming a first electrical connection to the doped region, which connection extends outward at least over a part of the insulating region; using the electrical connection as a mask, removing a part of the insulating region to expose the surface of the layer; and depositing a silicide-forming metal onto at least the surface of the layer to thereby form a low resistance shunt of metal silicide.

In most embodiments the first portion of the layer will be the emitter and the second portion the extrinsic base, while aluminum is employed as the electrical contact. By using an anisotropic etching process which attacks silicon dioxide, but not silicon or aluminum, the aluminum contacts mask the silicon dioxide. Thus, all of the silicon dioxide except a small region beneath the emitter contact and adjacent the emitter will be removed. A layer of silicide-forming metal may then be deposited onto the now nearly completely exposed extrinsic base. By employing a metal, such as nickel or copper, which forms silicide below the melting point of aluminum, the silicide may be formed without destroying the interconnections. Unreacted metal may then be selectively etched from the structure.

The process of our invention results in a unique structure. In a preferred embodiment, a semiconductor structure fabricated according to our invention includes a layer of first conductivity type semiconductor material having an upper surface; a first doped region of opposite conductivity type extending into the layer from the surface; an electrical connection to the first region disposed over the surface to contact only the first region, an overhanging portion of the electrical connection having an edge extending beyond the first region over the layer, but separated therefrom; a first insulating region disposed between the overhanging portion of the electrical connection and the layer and having an edge, the edge of the electrical connection and the edge of the insulating region being aligned, one atop the other; and a silicide region extending into the layer adjacent the insulating region, the silicide region also including an edge aligned with the edge of the insulating region. In a preferred embodiment, another edge of the silicide region will correspond with an edge of an additional electrical connection to the layer itself. As with the process of our invention, the first doped region typically will be an emitter, while the silicide will comprise copper or nickel.

BRIEF DESCRIPTION OF THE DRAWINGS

Figure 1a is a cross-sectional view of a prior art semiconductor structure;
Figure 1b is a top view of the structure of Figure 1a illustrating the high extrinsic base resistance of the structure;
Figures 2a-2g illustrate a preferred embodiment of the process of our invention where:

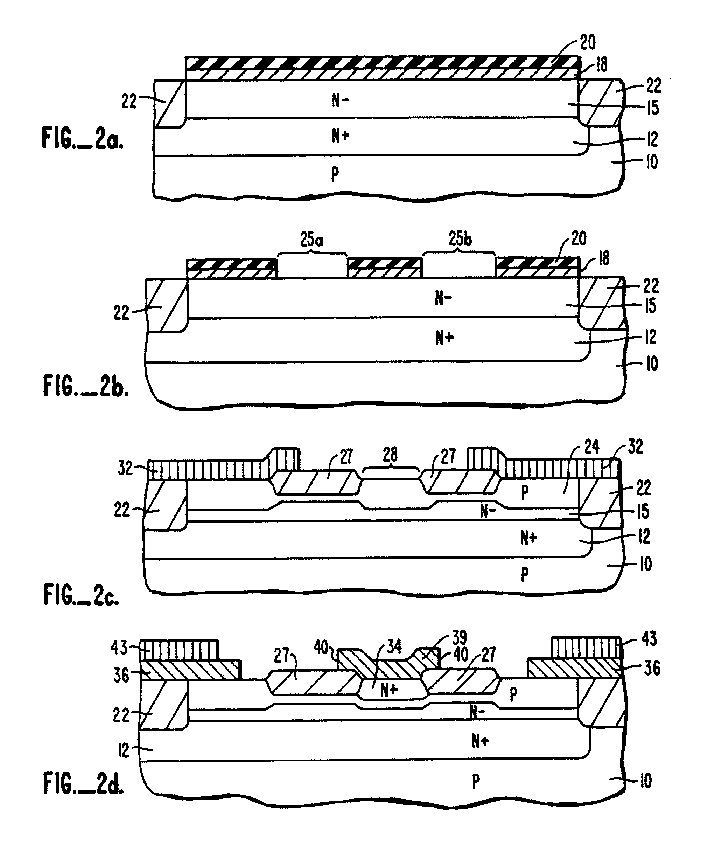

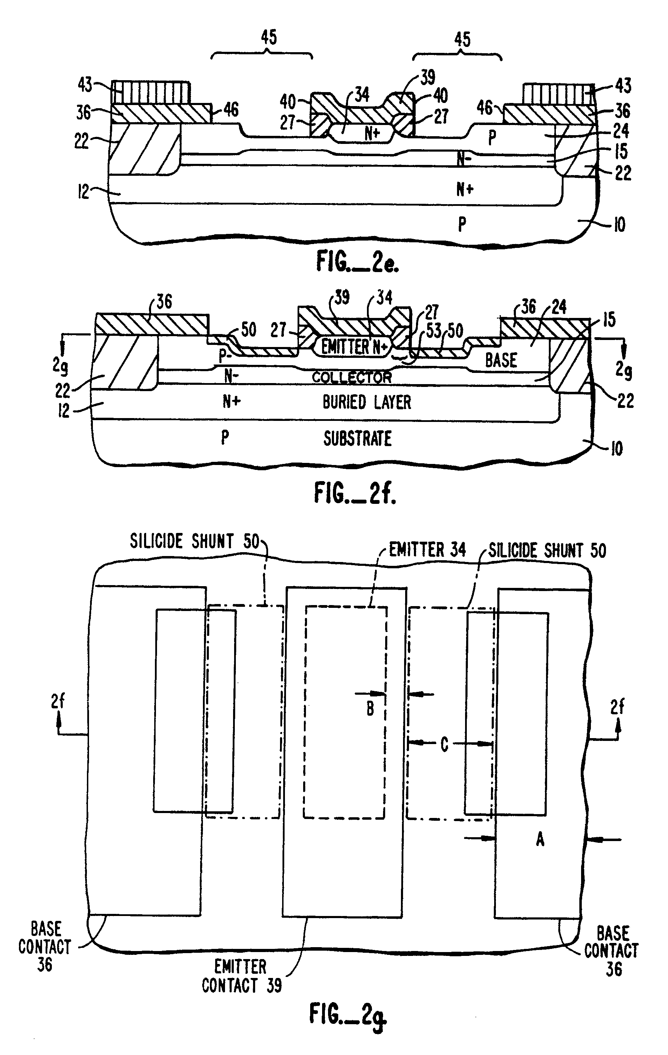

Figure 2a is a cross section of the semiconductor structure after formation of oxidized isolation regions;
Figure 2b is a subsequent cross section after definition of oxide and nitride masking layers;
Figure 2c is a subsequent cross section after additional oxidation of the epitaxial layer and formation of a mask;
Figure 2d is a subsequent cross section after formation of an emitter and electrical contacts to the base and emitter, as well as fabrication of another mask;
Figure 2e is a subsequent cross section after use of the metal contacts as a mask to etch the underlying structure;
Figure 2f is a subsequent cross section after formation of the silicide base shunts; and
Figure 2g is a top view of the structure shown in Figure 2f.

DETAILED DESCRIPTION OF THE PREFERRED EMBODIMENTS

Figures 2a-2g illustrate a preferred embodiment of the process of our invention, and the resulting structure. For clarity the vertical dimension in the figures is exaggerated. Figure 2a is a cross-sectional view of one well known semiconductor structure which may be used as a starting point for the process of our invention. The structure shown in Figure 2a includes a P conductivity type silicon substrate 10 having a resistivity of approximately 1-20 ohm centimeters. Inset into the surface of substrate 10 is a strongly-doped N conductivity type buried layer 12 having resistivity on the order of 3-10 ohms cm. Buried layer 12 will provide a buried connection to the collector region of a vertical NPN transistor. On the upper surface of buried layer 12, a lightly-doped N conductivity type epitaxial layer 15 is deposited, using well known semiconductor manufacturing techniques. Across the upper surface of layer 15, a relatively thin layer of silicon dioxide 18, on the order of 15-50 nm (150 - 500 Angstroms) thick, is grown using standard techniques. The choice of precise conductivities, thicknesses, etc., will depend upon the use to which the completed device will be applied.

On the upper surface of silicon dioxide layer 18, a layer of silicon nitride 20 is deposited, preferably using chemical vapor deposition. Nitride layer 20 typically will be 100-200 nm (1000-2000 Angstroms) thick. Using well known semiconductor photolithographic fabrication techniques and etchants, oxide and nitride layers 18 and 20 are patterned to expose regions of the underlying epitaxial layer 15 wherever insulating layers are desired. The structure is then oxidized using well known techniques to create oxidized isolation regions 22. If desired, a silicon etch and channel stop may precede the oxidation.

In the preferred embodiment silicon dioxide isolation 22 extends annularly through the epitaxial layer, around the portion of epitaxial layer 15 depicted, thereby creating an isolated pocket within which active and/or passive circuit components may be formed. At a cross section not depicted in the figures, but typically in the same silicon island, a contact will be formed to extend downward to connect to buried layer 12, thereby providing a buried connection (via buried layer) 12 to that lower portion of layer 15 which will eventually become the collector of the bipolar transistor. The process just described is discussed in further detail in the Peltzer patent referred to above. As will be evident, other isolation processes could also be employed.

Figure 2b is a subsequent cross-sectional view. Following the process described in Figure 2a, layers 18 and 20 are patterned to expose the upper surface of portions 25a and 25b of layer 15, whereby additional oxidized silicon is desired, for example, for a walled emitter structure. This may be achieved by using well known photolithographic techniques followed by wet or dry etches which attack the appropriate materials.

As next shown in Figure 2c, the structure is oxidized to form silicon dioxide region 27. Region 27, typically annular, will surround or separate a portion 28 of the surface of layer 15 from other portions of layer 15. The remaining silicon dioxide 18 and silicon nitride 20 is removed from the structure using conventional etchants. Then a layer of photoresist 32 is deposited and defined to expose the collector sink (not shown) which is doped with N-type impurity.

The photoresist is stripped and a new layer (not shown) deposited which exposes selected portions of layer 15 which will become the base regions of the transistor. Using this mask, a base region 24 is implanted into the upper surface of epitaxial layer 15. In the preferred embodiment, base region 24 is formed by implanting boron ions into the structure.

As shown in Figure 2c, the mask is removed and another photoresist mask 32 is defined. Suitable N conductivity type impurity, for example, arsenic, is introduced to create the walled emitter region 34 (see Figure 2d). In the preferred embodiment emitter 34 is doped to a concentration of $1x10^{20}$ atoms per cubic centimeter. Next, as also shown in Figure 2d, a layer of electrically conductive material 36 is deposited across the structure and defined into base 36 and emitter 39 contacts. Importantly, edges 40 of layer 39 extend beyond the edges of emitter 34 onto silicon dioxide regions 27. This is a result of the original layout of the structure.

In the preferred embodiment, contacts 36 and 39 are aluminum on the order of 500-1000 nm (5000-10000 Angstroms) thick. Typically, the aluminum will include small amounts of copper, to minimize electromigration, and silicon, to minimize dissolution of the silicon substrate into the aluminum at the time of contact deposition. In another embodiment of the invention, however, contacts 36, 39 will comprise polycrystalline silicon doped with suitable impurity during or after deposition to render it sufficiently conductive.

After the conductive layer is patterned to define contacts 36 and 39, an additional layer of photoresist 43 is deposited across the structure and defined as shown in Figure 2d. The photoresist 43 will protect otherwise exposed regions of the semiconductor structure from subsequent processing steps.

Figure 2e illustrates the next stage of our process. Using electrically conductive regions 36 and 39 as a mask, exposed portions of silicon dioxide region 27 are etched from the surface of the structure. In the preferred embodiment, this is achieved by employing commercially available fluorine based plasma. The plasma does not attack aluminum, silicon, or photoresist, but does attack silicon dioxide. The silicon dioxide is etched for a sufficient period (dependent on its thickness) to etch completely through regions 27 to expose the underlying portions of the base region 24. In this manner any silicon dioxide within regions 45 will be removed, with the edges 40 and 46 of connections 39 and 36, respectively, defining the width of the region to be etched. After etching, the structure will appear as depicted in Figure 2e, that is, an overhanging portion of connection 39 will extend beyond the edges of emitter 34, yet be separated from the base region 24 by small remaining silicon dioxide regions 27.

Figure 2f depicts the next steps in our process. A silicide-forming metal is deposited across the entire upper surface of the structure, including the newly exposed upper surface of the extrinsic base 24. The structure is then heated to a temperature sufficient to cause the metal to react with the underlying silicon to form metal silicide regions 50. Importantly, in the preferred embodiment a metal such as nickel or copper is employed which forms a silicide at a sufficiently low temperature so as not to melt the aluminum interconnections 36 and 39 already in place. Once the silicide has been formed, unreacted metal which remains on aluminum 36 or 39, or on the sides of region 27, may be stripped with an appropriate etchant, for example, dilute nitric acid for nickel or copper. If polysilicon contacts are employed in place of aluminum, the suitable metals for silicide formation include platinum, paladium, titanium, and tungsten, as well as others.

In the embodiment where connections 36 and 39 are polysilicon, the deposited metal will react with the polysilicon to form a region of metal silicide on the upper surface of connections 36 and 39, thereby diminishing their resistance. As described above, any metal deposited on silicon dioxide 27, or other regions not depicted in the figures, may be removed using an appropriate etchant.

The result of our described process is to create the structure shown in Figure 2f. As shown, a low resistance metal silicide shunt 50 extends from the base contact 36 toward emitter 34. Shunt 50 extends to within a very short distance 53 of emitter 34, thereby substantially minimizing the extrinsic base resistance. Distance 53 will be determined by the extent to which silicon dioxide 27 encroaches beneath the mask formed by oxide 18 and nitrite 20, by the extent to which the emitter 34 diffuses beneath and beyond the tip of that encroachment, and by the designed overlap of the contact metal over the oxide.

Figure 2g is a top view of the structure shown in Figure 2f. The emitter contact 39 is shown overlying emitter 34 and extending beyond the periphery of emitter 34. Also shown are the base shunt 50 and base contacts 36. The particular advantage of the base shunt may be appreciated by comparing Figure 1b with Figure 2g. The dimension B of the extrinsic base has been substantially reduced. Most of the distance B + C between the base contact 36 and the edge of emitter 34 is now occupied by the silicide shunt 50. The resistivity of the silicide shunt 50 will be on the order of 1-20 ohms per square, in contrast with the resistance of about 200-2000 ohms per square for the extrinsic base. This substantial decrease in resistance of the extrinsic base allows the transistor to switch at higher speeds than transistors formed without the silicide shunt.

## Claims

1. A process for fabricating a low resistance shunt for a semiconductor structure comprising:

   a) in a layer (24) of first conductivity type silicon semiconductor material having a surface, forming an insulating region (27) of oxidized semiconductor material to separate at the surface a first portion (28) of the layer from a second portion;

   b) introducing opposite conductivity type impurity into the first portion to thereby form a first region (34) in contact with the insulating region;

   c) forming a first electrical connection (39) to the first region, which connection extends at least over a part of the insulating region;

   d) using the electrical connection as a mask, removing a part of the insulating region to expose the surface of the layer; and

   e) depositing a silicide-forming metal onto at least the surface of the layer to form a low resistance shunt of metal silicide (50).

2. A process as in Claim 1 further comprising the step of:

   forming a second electrical connection (36) to the layer of first conductivity type semiconductor material, which second electrical connection is spaced apart from the first electrical connection.

3. A process as in Claim 2 wherein the step of using the first electrical connection (39) as a mask further comprises also using the second electrical connection (36) as a mask.

4. A process as in Claim 1 wherein the first electrical connection comprises aluminum.

5. A process as in Claim 4 wherein the silicide-forming metal comprises copper.

6. A process as in claim 4 wherein the silicide-forming metal comprises nickel.

7. A process as in Claim 1 wherein the first electrical connection (39) comprises polycrystalline silicon.

8. A process as in Claim 1 wherein the step of removing a part of the insulating region (27) comprises etching the insulating region with a fluorine containing plasma.

9. A process as in claim 1 wherein the opposite conductivity type impurity comprises N conductivity type and the first region (34) comprises an emitter of a transistor.

10. A process as in Claim 1 wherein the step of depositing is followed by the step of heating the semiconductor structure to cause the silicide-forming metal to react with the layer.

11. A process as in Claim 10 wherein the first electrical connection has a melting point and the structure is heated to a temperature below the melting point of the first electrical connection.

12. A process as in Claim 11 followed by the step of removing from the structure any of the silicide-forming metal which does not react with the silicon layer.

13. A process as in Claim 12 wherein the silicide-forming metal comprises nickel and the step of removing comprises etching with dilute nitric acid.

14. A process for fabricating a low resistance silicide shunt (50) for a vertical bipolar transistor comprising:

a) in a layer (24) of P conductivity type silicon semiconductor material having an upper surface, forming an insulating region (27) of oxidized silicon to separate at the surface of the layer an emitter region (34) from a base region;

b) introducing N conductivity type impurity into the emitter region to thereby form an emitter in contact with the insulating region;

c) forming an aluminum connection (39) to the emitter, which connection extends at least over a part of the oxidized silicon;

d) using the aluminum connection and a base contact (36) as a mask, plasma etching the oxidized silicon to expose the surface of the silicon layer except where protected by the aluminum connection;

e) depositing a metal selected from the group of copper and nickel across the silicon;

f) heating the metal to a temperature below the melting point of aluminum to thereby form the low resistance silicide shunt; and

g) removing any of the silicideforming metal remaining unreacted on the semiconductor structure.

15. A semiconductor structure comprising:

a) a layer (24) of first conductivity type silicon semiconductor material having an upper surface;

b) a first region (34) of opposite conductivity type extending into the layer from the surface;

c) a first electrical connection (39) to the first region disposed over the surface to contact only the first region, an overhanging portion of the first electrical connection having an edge (40) extending beyond the first region over the layer, but separated therefrom;

d) a first insulating region (27) disposed between the overhanging portion of the electrical connection and the layer, and having an edge, the edge of the electrical connection and the edge of the insulating region being aligned, one above the other; and

e) a silicide region (50) extending into the layer adjacent the insulating region, the silicide region also including an edge aligned with the edge of the insulating region.

16. A structure as in Claim 15 further comprising a second electrical connection (36) disposed over the surface of the layer of first conductivity type semiconductor material and separated from the edge of the insulating region by the silicide region.

17. A structure as in Claim 16 wherein each of the first (39) and second (36) electrical connections comprise aluminum.

18. A structure as in Claim 16 wherein each of the first (39) and second (36) electrical connections comprise polycrystalline silicon.

19. A structure as in Claim 15 wherein the first region (34) comprises an emitter of a bipolar transistor, and the layer of first conductivity type (24) comprises a base of the bipolar transistor.

20. A structure as in Claim 15 wherein the silicide region comprises nickel silicide.

21. A structure as in Claim 15 wherein the silicide region comprises copper silicide.

22. A structure as in Claim 20 wherein the first insulating region comprises silicon dioxide.

**Revendications**

1. Procédé pour fabriquer un shunt à faible résistance pour une structure semi-conductrice comprenant :

a) dans une couche (24) d'un matériau semi-conducteur en silicium d'un premier type de conductivité ayant une surface, la formation d'une région isolante (27) en matériau semi-conducteur oxydé pour séparer à la surface une première partie de la couche d'une seconde partie;

b) l'introduction d'une impureté du type de conductivité opposée dans la première partie pour former ainsi une première région (34) en contact avec la région isolante;

c) la formation d'une première connexion électrique (39) avec la première région, ladite connexion s'étendant au moins sur une partie de la région isolante;

d) l'utilisation de la connexion électrique en tant que masque, le retrait d'une partie de la région isolante pour exposer la surface de la couche; et

e) le dépôt d'un métal formant un siliciure sur au moins la surface de la couche pour former un shunt (50) à faible résistance en siliciure de métal.

2. Procédé selon la revendication 1 comprenant en outre l'opération consistant à :
- former une seconde connexion électrique (36) avec la couche en matériau semi-conducteur du premier type de conductivité, la seconde connexion électrique étant espacée de la première connexion électrique.

3. Procédé selon la revendication 2, dans lequel l'opération consistant à utiliser la première connexion électrique en tant que masque comprend en outre l'utilisation de la seconde connexion électrique (36) également en tant que masque.

4. Procédé selon la revendication 1, dans lequel la première connexion électrique comprend de l'aluminium.

5. Procédé selon la revendication 4, dans lequel le métal formant un siliciure comprend du cuivre.

6. Procédé selon la revendication 4, dans lequel le métal formant un siliciure comprend du nickel.

7. Procédé selon la revendication 1, dans lequel la première connexion électrique comprend du silicium polycristallin.

8. Procédé selon la revendication 1, dans lequel l'opération consistant à retirer une partie de la région isolante, comprend une gravure de la région isolante avec un plasma contenant du fluor.

9. Procédé selon la revendication 1, dans lequel l'impureté de type de conductivité opposée comprend un type de conductivité N et la première région comprend un émetteur d'un transistor.

10. Procédé selon la revendication 1, dans lequel l'opération de dépôt est suivie de l'opération de chauffage de la structure semi-conductrice pour faire réagir le métal formant un siliciure avec la couche.

11. Procédé selon la revendication 10, dans lequel la première connexion électrique a un point de fusion et dans lequel la structure est chauffée à une température inférieure au point de fusion de la première connexion électrique.

12. Procédé selon la revendication 11 suivi par l'opération de retrait de la structure de tout le métal formant un siliciure qui ne réagit pas avec la couche de silicium.

13. Procédé selon la revendication 12, dans lequel le métal formant un siliciure comprend du nickel et dans lequel l'opération de retrait comprend une gravure avec de l'acide nitrique dilué.

14. Procédé pour fabriquer un shunt (50) en siliciure à faible résistance pour un transistor bipolaire vertical comprenant :
a) dans une couche (24) d'un matériau semi-conducteur en silicium d'un type de conductivité P ayant une surface supérieure, la formation d'une région isolante (27) en silicium oxydé pour séparer à la surface de la couche une région d'émetteur (34) d'une région de base;
b) l'introduction d'une impureté de type de conductivité N dans la région d'émetteur pour former ainsi un émetteur en contact avec la région isolante;
c) la formation d'une connexion (39) en aluminium avec l'émetteur, la connexion s'étendant au moins au-dessus d'une partie du silicium oxydé;
d) l'utilisation de la connexion en aluminium et d'un contact de base (36) en tant que masque, une gravure au plasma du silicium oxydé pour exposer la surface de la couche de silicium à l'exception des endroits protégés par la connexion en aluminium;
e) le dépôt d'un métal sélectionné dans le groupe comprenant le cuivre et le nickel en travers du silicium;
f) le chauffage du métal à une température en-dessous du point de fusion de l'aluminium pour former ainsi un shunt en siliciure à faible résistance; et
g) le retrait de tout le métal formant du siliciure qui n'a pas réagi restant sur la structure semi-conductrice.

15. Structure semi-conductrice comprenant :
a) une couche (24) d'un matériau semi-conducteur en silicium d'un premier type de conductivité ayant une surface supérieure;
b) une première région (34) du type de conductivité opposée s'étendant dans la couche à partir de la surface;
c) une première connexion électrique (39) avec la première région disposée sur la surface pour mettre en contact seulement la première région, une portion en surplomb de la première connexion électrique ayant un bord (40) s'étendant au-delà de la première région sur la couche mais séparée de celle-ci;

d) une première région isolante (27) disposée entre la partie en surplomb de la connexion électrique et la couche, et ayant un bord, le bord de la connexion électrique et le bord de la région isolante étant alignés, l'un au-dessus de l'autre;

e) une région de siliciure (50) s'étendant dans la couche adjacente à la région isolante, la région de siliciure comprenant également un bord aligné avec le bord de la région isolante.

16. Structure selon la revendication 15, comprenant en outre une seconde connexion électrique (36) disposée sur la surface de la couche de matériau semiconducteur du premier type de conductivité et séparée du bord de la région isolante par la région de siliciure.

17. Structure selon la revendication 16, dans laquelle chacune des première et seconde connexions électriques comprend de l'aluminium.

18. Structure selon la revendication 16, dans laquelle chacune des première et seconde connexions électriques comprend du silicium polycristallin.

19. Structure selon la revendication 15, dans laquelle la première région comprend un émetteur d'un transistor bipolaire, et la couche du premier type de conductivité comprend une base du transistor bipolaire.

20. Structure selon la revendication 15, dans laquelle la région de siliciure comprend du siliciure de nickel.

21. Structure selon la revendication 15, dans laquelle la région de siliciure comprend du siliciure de cuivre.

22. Structure selon la revendication 20, dans laquelle la première région isolante comprend du dioxyde de silicium.

**Patentansprüche**

1. Ein Verfahren für die Herstellung eines Nebenschlusses niedrigen Widerstandes für eine Halbleiterstruktur, umfassend:

a) in einer Schicht (24) eines Siliciumhalbleitermaterials ersten Leitfähigkeitstyps mit einer Oberfläche - Bilden eines isolierenden Bereiches (27) aus oxidiertem Halbleitermaterial zum Abgrenzen an der Oberfläche eines ersten Bereiches der Schicht von einem zweiten Bereich;

b) Einführen von Dotierungsmittel entgegengesetzten Leitfähigkeitstyps in den ersten Abschnitt, um dadurch einen ersten Bereich (34) in Kontakt mit dem isolierenden Bereich zu bilden;

c) Bilden einer ersten elektrischen Verbindung (39) zu dem ersten Bereich, welche Verbindung sich mindestens über einen Teil des isolierenden Bereichs erstreckt,

d) Abtrag, unter Verwendung der elektrischen Verbindung als Maske, eines Teils des isolierenden Bereichs zum Freilegen der Oberfläche der Schicht; und

e) Aufbringen eines silicidbildenden Metalls auf mindestens die Oberfläche der Schicht zum Bilden eines Nebenschlusses niedrigen Widerstandes aus Metallsilicid (50).

2. Ein Verfahren nach Anspruch 1, ferner umfassend den Schritt:
Bilden einer zweiten elektrischen Verbindung (36) zu der Schicht aus Halbleitermaterial ersten Leitfähigkeitstyps, welche zweite elektrische Verbindung beabstandet ist von der ersten elektrischen Verbindung.

3. Ein Verfahren nach Anspruch 2, bei dem der Schritt der Verwendung der ersten elektrischen Verbindung als Maske ferner die Verwendung auch der zweiten elektrischen Verbindung (36) als Maske umfaßt.

4. Ein Verfahren nach Anspruch 1, bei dem die erste elektrische Verbindung Aluminium umfaßt.

5. Ein Verfahren nach Anspruch 4, bei dem das silicidbildende Metall Kupfer umfaßt.

6. Ein Verfahren nach Anspruch 4, bei dem das silicidformende Metall Nickel umfaßt.

7. Ein Verfahren nach Anspruch 1, bei dem die erste elektrische Verbindung polykristallines Silicium umfaßt.

8. Ein Verfahren nach Anspruch 1, bei dem der Schritt des Abtrags eines Teils des isolierenden Bereichs das Ätzen des isolierenden Bereiches mit einem Fluor enthaltenden Plasma umfaßt.

9. Ein Verfahren nach Anspruch 1, bei dem das Dotierungsmittel entgegengesetzten Leitfähigkeitstyps N Leitfähigkeitstyp umfaßt und der erste Bereich einen Emitter eines Transistors umfaßt.

10. Ein Verfahren nach Anspruch 1, bei dem dem Schritt des Aufbringens der Schritt des Erhitzens der Halbleiterstruktur folgt zum Bewirken der Reakation des silicidbildenden Metalls mit der Schicht.

11. Ein Verfahren nach Anspruch 10, bei dem die erste elektrische Verbindung einen Schmelzpunkt aufweist und die Struktur auf eine Temperatur erhitzt wird unterhalb des Schmelzpunktes der ersten elektrischen Verbindung.

12. Ein Verfahren nach Anspruch 11, gefolgt von dem Schritt des Abtrags solchen silicidbildenden Metalls von der Struktur, daß nicht mit der Siliciumschicht reagiert.

13. Ein Verfahren nach Anspruch 12, bei dem das silicidbildende Metall Nickel umfaßt und der Schritt des Abtrags Ätzen mit verdünnter Salpetersäure umfaßt.

14. Ein Verfahren für die Herstellung eines Silicidnebenschlusses niedrigen Widerstandes für einen vertikalen bipolaren Transistor, umfassend:
    a) in einer Schicht (24) von P-leitendem Siliciumhalbleitermaterial mit einer oberen Oberfläche - Bilden eines isolierenden Bereiches (27) aus oxidiertem Silicium zum Abgrenzen, an der Oberfläche der Schicht, eines Emitterbereiches (34) von einem Basisbereich;
    b) Einführen von N-leitendem Dotierungsmittel in den Emitterbereich, um dadurch einen Emitter in Kontakt mit dem isolierenden Bereich zu bilden;
    c) Bilden einer Aluminiumverbindung (39) zu dem Emitter, welche Verbindung sich mindestens über einen Teil des oxidierten Siliciums erstreckt,
    d) unter Verwendung der Aluminiumverbindung und eines Basiskontakts (36) als Maske - Plasmaätzen des oxidierten Siliciums zum Freilegen der Oberfläche der Siliciumschicht ausgenommen dort, wo sie durch die Aluminiumverbindung geschützt ist;
    e) Aufbringen eines Metalls, ausgewählt aus der Gruppe von Kupfer und Nickel, auf das Silicium;
    f) Erhitzen des Metalls auf eine Temperatur unterhalb des Schmelzpunktes von Aluminium, um dadurch den Silicidnebenschluß niedrigen Widerstandes zu bilden; und
    g) Abtrag allen silicidbildenden Metalls, das unreagiert auf der Halbleiterstruktur verblieben ist.

15. Eine Halbleiterstruktur, umfassend:
    a) eine Schicht (24) von Siliciumhalbleitermaterial ersten Leitfähigkeitstyps mit einer oberen Oberfläche;
    b) einen ersten Bereich (34) entgegengesetzten Leitfähigkeitstyps, der sich in die Schicht von der Oberfläche her erstreckt,
    c) eine erste elektrische Verbindung (39) zu dem ersten Bereich, angeordnet über der Oberfläche zum Kontaktieren nur den ersten Bereiches, wobei ein überhängender Abschnitt der ersten elektrischen Verbindung eine Kante (40) besitzt, die sich über den ersten Bereich über der Schicht hinaus erstreckt, jedoch davon getrennt ist,
    d) einen ersten isolierenden Bereich (27), angeordnet zwischen dem überhängenden Bereich der elektrischen Verbindung und der Schicht und mit einer Kante, wobei die Kante der elektrischen Verbindung und die Kante des isolierenden Bereiches ausgefluchtet übereinander liegen; und
    e) einen Silicidbereich (50), der sich in die Schicht nahe dem isolierenden Bereich erstreckt, welcher Silicidbereich ebenfalls eine Kante aufweist, die ausgefluchtet ist mit der Kante des isolierenden Bereichs.

16. Eine Struktur nach Anspruch 15, ferner umfassend eine zweite elektrische Verbindung (36), die über der Oberfläche der Schicht von Halbleitermaterial ersten Leitfähigkeitstyps angeordnet ist und von der Kante des isolierenden Bereichs durch den Silicidbereich getrennt ist.

17. Eine Struktur nach Anspruch 16, bei der jede der ersten und zweiten elektrischen Verbindungen Aluminium umfaßt.

18. Eine Struktur nach Anspruch 16, bei der jede der ersten und zweiten elektrischen Verbindungen polykristallines Silicium umfaßt.

19. Eine Struktur nach Anspruch 15, bei der der erste Bereich (34) einen Emitter eines bipolaren Transistors umfaßt und die Schicht ersten Leitfähigkeitstyps eine Basis des bipolaren Transistors umfaßt.

20. Eine Struktur nach Anspruch 15, bei der der Silicidbereich Nickelsilicid umfaßt.

**21.** Eine Struktur nach Anspruch 15, bei der der Silicidbereich Kupfersilicid umfaßt.

**22.** Eine Struktur nach Anspruch 20, bei der der erste isolierende Bereich Siliciumdioxid umfaßt.

FIG.__Ia.(PRIOR ART)

FIG.__Ib. (PRIOR ART)

FIG._2a.

20
18
22
N−
15
N+
12
10
P
22

FIG._2b.

25a
25b
20
18
N−
22
15
N+
12
10
P
22

FIG._2c.

27
28
27
24
32
32
P
22
N−
15
N+
12
10
P

FIG._2d.

43
39
43
36
27
40
34
40
27
36
N+
P
22
N−
12
N+
10
P

FIG._2e.

FIG._2f.

FIG._2g